Europäisches Patentamt

European Patent Office

Office européen des brevets

(19)

(11) Veröffentlichungsnummer: **0 415 081 A2**

# EUROPÄISCHE PATENTANMELDUNG

(12)

(21) Anmeldenummer: 90114328.9

(22) Anmeldetag: 26.07.90

(51) Int. Cl.⁵: **H03K 17/06**

(30) Priorität: 01.09.89 DE 3929026

(43) Veröffentlichungstag der Anmeldung:
06.03.91 Patentblatt 91/10

(84) Benannte Vertragsstaaten:
**DE FR GB**

(71) Anmelder: **ROBERT BOSCH GMBH**
**Postfach 10 60 50**
**W-7000 Stuttgart 10(DE)**

(72) Erfinder: **Fischer, Werner, Dipl.-Ing.**
**Dickenbergstrasse 9/1**
**W-7258 Heimsheim(DE)**
Erfinder: **Barth, Jörg, Dipl.-Ing. (FH)**
**Merowingerstrasse 10**
**W-7130 Mühlacker-Lienzingen(DE)**
Erfinder: **Schönfelder, Dietbert**
**Bardiliweg 14**
**W-7000 Stuttgart 1(DE)**

(54) **Ansteuerschaltung für eine getaktete Last in einem Fahrzeug.**

(57) Eine Schaltung zum getakteten Ansteuern einer Last in einem Fahrzeug weist einen N-Kanal-Enhancement-MOSFET (MF) auf, der die zu taktende Last (L) in seinem Durchlaßzustand mit dem positiven Potential einer Batterie versorgt. Der andere Anschluß der Last ist auf Masse gelegt. Der MOSFET wird von einer Schalteinrichtung (SE) getaktet. Die Schalteinrichtung gibt abwechselnd eines von zwei Potentialen auf das Gate (G) des MOSFET. Das eine Potential ist das Batteriepotential. Das andere Potential ist eines, das am Verbindungspunkt (V) zwischen einer Diode (D) und einem Kondensator (C) abgegriffen wird. Die Diode und der Kondensator sind zwischen den Batterieanschluß und die Source (S) des MOSFET geschaltet. Der Kondensator wirkt als Pumpkondensator innerhalb einer Pumpschaltung, die dazu dient, bei durchgeschaltetem MOSFET das Gatepotential auf einen höheren Wert zu heben, als er dem Batteriepotential entspricht.

Bei einer solchen Ansteuerschaltung hat die Schalteinrichtung Doppelfunktion. Sie wirkt nämlich zugleich als Schalteinrichtung zum Takten des MOSFET wie auch als Schalteinrichtung innerhalb einer Pumpenschaltung.

Fig. 1

EP 0 415 081 A2

# ANSTEUERSCHALTUNG FÜR EINE GETAKTETE LAST IN EINEM FAHRZEUG

Die Erfindung betrifft eine Ansteuerschaltung für eine getaktete Last in einem Fahrzeug. Wenn es sich bei der Last um einen Steller handelt, erfolgt das Takten mit relativ niedriger Frequenz, z. B. mit etwa 70 Hz bei einem Leerlaufsteller oder etwa 140 Hz bei einem Abgasrückführsteller oder einem Drosselklappensteller. Handelt es sich bei der Last um einen Transformator, z. B. um einen solchen zum Erzeugen einer Hochspannung für eine Rußverbrennungseinrichtung, wird typischerweise mit einigen 10 kHz getaktet.

## Stand der Technik

Problematisch beim Ansteuern einer getakteten Last in einem Fahrzeug ist, daß dort üblicherweise die Last einseitig direkt mit Masse verbunden wird, die ihrerseits an den negativen Anschluß einer Batterie geschaltet ist. Der Schalter zum Takten der Last muß sich somit zwischen dieser und dem positiven Anschluß der Batterie befinden. Zum Schalten werden vorzugsweise MOSFETs verwendet. Bei den genannten Potentialverhältnissen müßte ein P-Kanal-MOSFET verwendet werden. Derartige MOSFETs sind jedoch relativ teuer und in den üblichen Ausführungsformen nicht dazu in der Lage, die auftretenden Ströme zu schalten.

Die in der Praxis verwendeten Ansteuerschaltungen für getaktete Lasten in einem Fahrzeug weisen daher einen N-Kanal-MOSFET als Schalter auf, und zwar grundsätzlich einen solchen vom Enhancement-Typ, da es dann auf einfache Weise möglich ist, ein Abschalten dadurch vorzunehmen, daß der Potentialunterschied zwischen Gate und Source im wesentlichen aufgehoben wird.

Wird ein N-Kanal-Enhancement-MOSFET als Schalter eingesetzt, muß dieser zwischen der Last und dem negativen Anschluß der Batterie liegen. Die Last kann also nicht mehr direkt mit Fahrzeugmasse verbunden werden. Dies bedeutet, daß alle getakteten Lasten mit zwei gesonderten Leitungen angeschlossen werden müssen, nämlich mit der üblichen Zuführleitung für das positive Potential und darüber hinaus mit einer Leitung vom Steuergerät, das den schaltenden MOSFET enthält.

Um auch getaktete Lasten in üblicher Weise einseitig direkt mit Fahrzeugmasse verbinden zu können, werden auch spezielle Ansteuerschaltungen mit gesonderter Pumpenschaltung zum Ansteuern des N-Kanal-Enhancement-MOSFET verwendet. Diese erzeugen ein Potential, das um mindestens die Gate-Source-Schwellenspannung über dem positiven Batteriepotential liegt. Dadurch kann der MOSFET nach seinem Durchschalten in geschlossenem Zustand gehalten werden, da sein Gatepotential dauernd über dem Sourcepotential liegt, das bei durchgeschaltetem Transistor im wesentlichen dem Drainpotential und damit dem Potential des positiven Batterieanschlusses entspricht.

Es besteht seit langem der Wunsch, über eine Ansteuerschaltung für eine getaktete Last in einem Fahrzeug zu verfügen, in der ein N-Kanal-Enhancement-MOSFET als Schalter auch dann verwendet werden kann, wenn die Last einseitig mit Masse verbunden ist, aber trotzdem keine zusätzliche Pumpenschaltung erforderlich ist.

## Darstellung der Erfindung

Die erfindungsgemäße Ansteuerschaltung ist so aufgebaut, daß die Schalteinrichtung zum Schalten des MOSFET, also zum getakteten Ansteuern der Last, zugleich Teil einer Pumpenschaltung ist. Dies wird dadurch erreicht, daß die Source des MOSFET über eine Diode und einen Kondensator mit dem positiven Anschluß der Spannungsversorgung (Batterie) verbunden ist und die Schalteinrichtung so mit dem Verbindungspunkt zwischen Diode und Kondensator und so mit einem Masseanschluß und dem Gate des MOSFET verbunden ist, daß sie abwechselnd das Potential des Masseanschlusses bzw. das Potential des Verbindungspunktes auf das Gate legt.

Durch diese Beschaltung ist dafür gesorgt, daß sich immer dann, wenn die Schalteinrichtung den MOSFET abschaltet, am Kondensator eine Spannung aufbaut, die beim Wiedereinschalten des MOSFET zwischen Source und Gate gelegt wird. Die einzige Schalteinrichtung sorgt also für das getaktete Schalten des MOSFET und für das getaktete Laden des Kondensators.

Die Schalteinrichtung kann zwischen den genannten Verbindungspunkt und das Gate geschaltet sein, wobei das Gabe über einen Widerstand mit der Source verbunden ist. Es ist unmittelbar erkennbar, daß dann das Potential vom Verbindungspunkt am Gate liegt, wenn die Schalteinrichtung geschlossen ist. Ist sie geöffnet, wird das Gatepotential über den Widerstand auf Sourcepotential gezogen, welches über die Last auf Masse liegt. Bei dieser Beschaltung ist die Schalteinrichtung vorzugsweise durch einen pnp-Transistor gebildet, der über einen npn-Transistor angesteuert wird.

Nur mit einem einzigen Transistor in der Schalteinrichtung, nämlich einem npn-Transistor, kommt man aus, wenn die Ansteuer schaltung so ausgebildet wird, daß die Schalteinrichtung direkt gegen Massepotential schalten kann. In diesem Fall weist die Ansteuerschaltung zwei Widerstände zwischen dem genannten Verbindungspunkt und dem Gate des MOSFET auf und die Schalteinrichtung liegt zwischen dem Masseanschluß und dem Verbindungspunkt der Widerstände.


Zeichnung

Fig. 1 Schaltbild einer Ansteuerschaltung zum getakteten Ansteuern einer einseitig mit Masse verbundenen Last mit Hilfe eines N-Kanal-Enhancement-MOSFET;

Fig. 2a - c zeitkorrelierte Diagramme für ein Schaltersignal, ein Sourcesignal bzw. ein Gatesignal;

Fig. 3 detailliertes Schaltbild für die Ansteuerschaltung gemäß Fig. 1;

Fig. 4 Schaltbild für eine Ansteuerschaltung mit der Funktion der Schaltung gemäß Fig. 1; jedoch mit einer Schalteinrichtung, die gegen Masse schaltet;

Fig. 5 zeitkorrelierte Signaldiagramme entsprechend denen von Fig. 2; jedoch für die Schaltung gem. Fig. 4.


Beschreibung von Ausführungsbeispielen

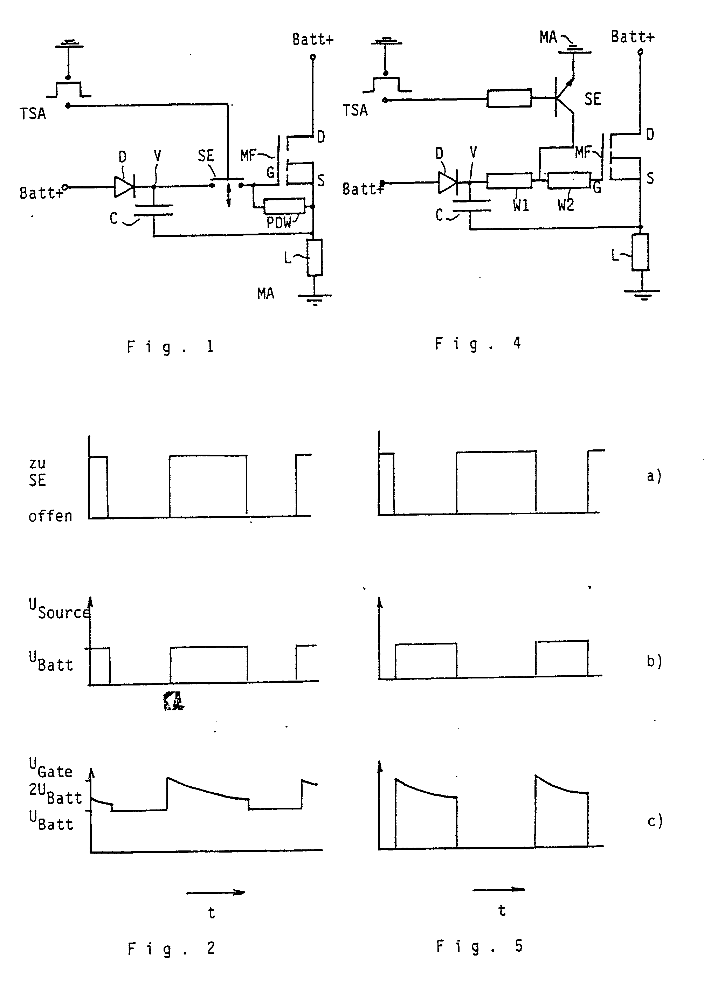

Die Schaltungen gemäß den Fig. 1, 3 und 4 verfügen alle über einen N-Kanal-Enhancement-MOSFET MF, dessen Drain D mit einem Anschluß Batt+ verbunden ist, der das Potential des positiven Batterieanschlusses führt. Zwischen der Source S des MOSFET und Masse liegt eine zu taktende Last L. Immer dann, wenn die Spannung zwischen dem Gate G und der Source S des MOSFET MF größer ist als eine Schwellenspannung, schaltet der MOSFET durch, wodurch die Last zwischen Masse und dem positiven Batteriepotential liegt. Der dann fließende Strom wird so lange aufrechterhalten, wie die Gate-Source-Spannung über der genannten Schwellenspannung liegt.

Sobald der MOSFET durchgeschaltet hat, liegt seine Source im wesentlichen auf dem positiven Batteriepotential. Das Gatepotential muß, wie vorstehend erläutert, um mindestens eine Schwellenspannung über dem Sourcepotential liegen. Die Potentialerhöhung ausgehend vom positiven Batteriepotential erfolgt mit Hilfe einer Pumpenschaltung. Diese verfügt über eine Diode D, einen Kondensator C und eine Schalteinrichtung SE, die zugleich für das getaktete Schalten des MOSFET MF sorgt. Die Diode D und der Kondensator C liegen zwischen dem Anschluß Batt+ und der Source des MOSFET MF. Die Schalteinrichtung SE wirkt zwischen dem Verbindungspunkt V zwischen Diode D und Kondensator C und dem Gate des MOSFET MF.

Bei der Ausführungsform gemäß Fig. 1 ist die Schalteinrichtung SE direkt zwischen den Verbindungspunkt V und das Gate G geschaltet. Sie öffnet und schließt im Takt eines Signals, das ihr über einen Taktsignalanschluß TSA zugeführt wird. Der zeitliche Verlauf dieses Taktsignals ist in Fig. 2a dargestellt. Die Schaltung verfügt weiterhin über einen Pulldown-Widerstand PDW zwischen Gate G und Source S.

Sobald die Schalteinrichtung SE öffnet, wird das Potential am Gate G über den Pulldown-Widerstand PDW auf das Potential der Source S gezogen. Dann sperrt der MOSFET MF. Das Sourcepotential fällt dann vom positiven Batteriepotential wegen der Masseverbindung über die Last L auf Massepotential. Dadurch liegt der Kondensator C zwischen Masse und dem positiven Batteriepotential, so daß er sich über die Diode D einerseits und die Last L andererseits auf die Batterspannung $U_{Batt}$ auflädt.

Wird nun die Schalteinrichtung SE durch ein entsprechendes Signal am Taktsignalanschluß TSA wieder geschlossen, gelangt positives Potential an das Gate, so daß der MOSFET MF durchlassend wird, da an Source zunächst noch Massepotential liegt. Sobald der MOSFET jedoch durchgeschaltet hat, springt das Sourcepotential auf das Batteriepotential, also auf die Spannung $U_{Batt}$ gegenüber Masse, wie dies in Fig. 2b dargestellt ist. Der sourceseitige Anschluß des Kondensators C springt damit ebenfalls auf positives Batteriepotential, was zur Folge hat, daß am Verbindungspunkt V das Potential auf doppeltes positives Batteriepotential, also auf die Spannung 2 x $U_{Batt}$ gegenüber Masse, steigt. Diese Spannung liegt über die Schalteinrichtung SE direkt am Gate G. Die Gate-Source-Spannung ist damit 2 x $U_{Batt}$ - $U_{Batt}$ also $U_{Batt}$. Der MOSFET bleibt daher geöffnet.

Wegen der Diode D kann sich der Kondensator C nicht in Richtung Batterie entladen, jedoch entlädt er sich langsam über den Pulldown-Widerstand PDW. Die Spannung am Gate sinkt daher langsam ab, wie dies in Fig. 2c dargestellt ist. Die Differenz zwischen den in den Fig. 2c und 2b dargestellten Spannungen ist die Gate-Source-Spannung. Diese sinkt langsam in Richtung Null ab. Würde die Schalteinrichtung SE ausreichend lang in geschlossenem Zustand gehalten, würde die Gate-Source-Spannung bis unter die oben genannte Schwellenspannung für das Durchschalten des MOSFET MF fallen. Dies hätte zur Folge, daß die Frequenz zum Takten der Last L nicht allein durch die Frequenz des Taktsignales bestimmt wäre, wie es am Taktsignalanschluß TSA angelegt wird, sondern die Entladezeitkonstante des aus dem Kondensator C und aus dem Pulldown-Widerstand PDW gebildeten RC-Gliedes würde die Taktfrequenz mit beeinflussen. Um dies zu vermeiden, wird das RC-Glied zweckmäßigerweise so dimensioniert, daß die Gate-Source-Spannung noch über der genannten Schwellenspannung liegt, wenn die Schalteinrichtung SE wieder öffnet und damit der geschilderte Ablauf von neuem beginnt.

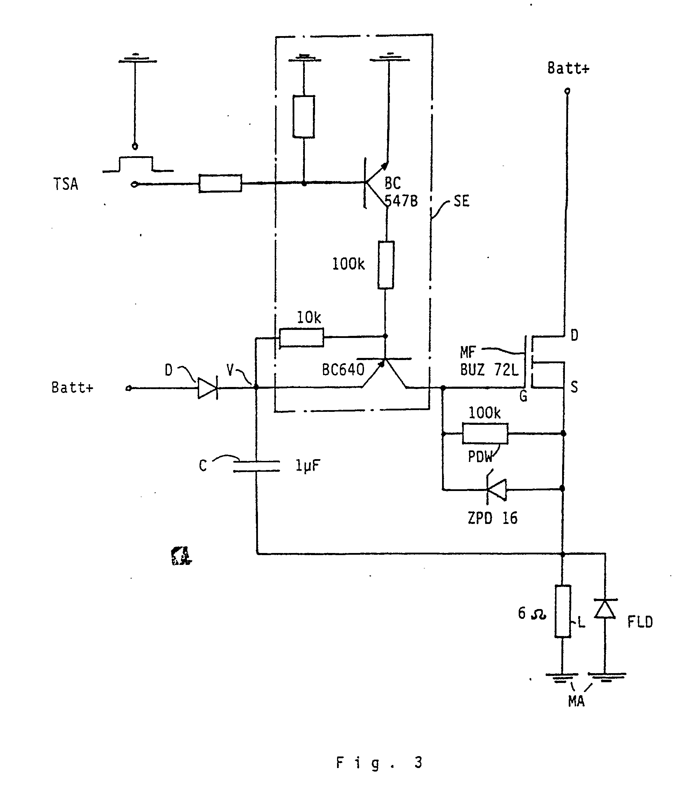

Fig. 3 stellt ein konkretes Ausführungsbeispiel der Schaltung von Fig. 1 mit Typbezeichnung und Dimensionierungsangaben für Bauteile dar. Die Schalteinrichtung SE weist einen pnp-Transistor auf, der potentialfrei über einen npn-Transistor mit dem Taktsignal vom Taktsignalanschluß TSA versorgt wird. Parallel zum Pulldown-Widerstand PDW liegt eine Zenerdiode, die dafür sorgt, daß die Gate-Source-Spannung am MOSFET MF einen vorgegebenen Höchstwert nicht überschreitet. Parallel zur Last L liegt eine Freilaufdiode FLD, die dafür sorgt, daß eine durch induktive Anteile der Last L hervorgerufene Spannung beim Abschalten der Last nicht den MOSFET MF zerstören kann.

Fig. 4 stellt eine andere Ausführungsform dar, bei der eine Schalteinrichtung SE in Doppelfunktion für das Schalten eines Kondensators in einer Pumpschaltung und außerdem für das Schalten eines MOSFET MF sorgt. Bei der Schaltung gemäß Fig. 4 liegen zwischen dem Verbindungspunkt V und dem Gate G des MOSFET MF ein erster Widerstand W1 und ein zweiter Widerstand W2. Die Schalteinrichtung SE liegt zwischen einem Masseanschluß MA und dem Verbindungspunkt der Widerstände W1, W2.

Sobald die Schalteinrichtung SE schließt, liegt das Potential vom Masseanschluß, also im wesentlichen Massepotential, über den zweiten Widerstand W2 am Gate G, so daß der MOSFET MF sofort sperrt. Dadurch fallen das Potential an der So9urce und damit auch am sourceseitigen Ende des Kondensators C auf Massepotential. Der Verbindungspunkt V bleibt jedoch aufgrund der Diode D auf positivem Batteriepotential.

Öffnet die Schalteinrichtung SE wieder, wird das Gatepotential nicht weiter auf das Potential des Masseanschlusses MA gezogen, sondern das Gate erhält das Potential des Verbindungspunktes V, also in etwa die doppelte Batteriespannung gegenüber Masse.

Diese Spannung fällt jedoch wiederum langsam ab, wie in Fig. 5c dargestellt. Dieses Abfallen ist jedoch langsamer als bei der Schaltung gemäß Fig. 1, da sich der Kondensator nur über Leckströme des npn-Transistors und über Innenwiderstände des MOSFET und ggf. einer zu Source und Gate parallelen Zenerdiode entlädt, aber nicht auch über einen Pulldown-Widerstand, da letzterer bei der Schaltung gemäß Fig. 4 fehlt. Es sei noch darauf hingewiesen, daß in Fig. 5b der zeitliche Verlauf der Sourcespannung dargestellt ist.

Die Schaltung gemäß Fig. 4 hat gegenüber der von Fig. 1 den Vorteil, daß wegen des Schaltens nach Masse in der Schalteinrichtung SE ein einzelner npn-Transistor verwendet werden kann, der unmittelbar durch das Taktsignal angesteuert wird. Der zusätzliche pnp-Transistor kann also entfallen. Der weitere Vorteil ist derjenige der vorstehend genannten längeren Entladezeit des Kondensators. Dadurch kann ein kleinerer Kondensator verwendet werden, um eine vorgegebene Entladezeit dennoch nicht zu unterschreiten.

Vorstehend wurde davon ausgegangen, daß die Spannungsversorgung der Schaltung durch eine Batterie erfolgt. Es kann jedoch jede beliebige Spannungsversorgung eingesetzt werden, insbesondere kann die Spannung von einer Lichtmaschine mit Spannungsregler abgegriffen werden..

Das Potential am Masseanschluß muß nicht notwendigerweise genau dem Potential des negativen Batterieanschlusses entsprechen. Durch irgendwelche Verlustwiderstände kann dieses Potential etwas höher liegen als das genannte Potential des negativen Anschlusses. Dies hat auf die Funktion der Schaltung keinen Einfluß.

Bei der Ausführungsform gemäß Fig. 1 könnte der Pulldown-Widerstand PDW statt an Source auch an einen Potentialanschluß gelegt sein, der ein Potential führt, das niedriger ist als die zum Leiten des MOSFET erforderliche Gate-Source-Spannung.

Die Schalteinrichtung kann in allen Fällen auch durch einen FET gebildet sein.

## Ansprüche

1. Schaltung zum getakteten Ansteuern einer Last in einem Fahrzeug, mit
- einem N-Kanal-Enhancement-MOSFET (MF) zum Schalten der einseitig mit Masse verbundenen Last (L), dessen Drain (D) mit dem positiven Anschluß einer Spannungsversorgung und dessen Source (S) mit der Last verbunden ist, und
- einer Schalteinrichtung (SE) zum Schalten des MOSFET;
dadurch gekennzeichnet, daß
- die Source des MOSFET über eine Diode (D) und einen Kondensator (C) mit dem positiven Anschluß der Spannungsversorgung verbunden ist, und
- die Schalteinrichtung so mit dem Verbindungspunkt (V) zwischen Diode und Kondensator und so mit einem Masseanschluß (MA) und dem Gate (G) des MOSFET verbunden ist, daß sie abwechselnd das Potential des Masseanschlusses bzw. das Potential des Verbindungspunktes auf das Gate legt.

2. Schaltung nach Anspruch 1, dadurch gekennzeichnet, daß die Schalteinrichtung (SE) zwischen den Verbindungspunkt (V) und das Gate (G) geschaltet ist und das Gate über einen Widerstand (PDW) mit einem Potentialanschluß verbunden ist, dessen Potential niedriger ist als die zum Leiten des MOSFET erforderliche Gate-Source-Spannung.

3. Schaltung nach Anspruch 2, **dadurch gekennzeichnet,** daß das Gate (G) über den Widerstand (PDW) mit der Source (S) verbunden ist.

4. Schaltung nach Anspruch 2, **dadurch gekennzeichnet,** daß die Schalteinrichtung (SE) einen npn-Transistor oder einen FET aufweist, der über einen pnp-Transistor angesteuert wird.

5. Schaltung nach Anspruch 1, **dadurch gekennzeichnet,** daß das Gate (G ) über einen ersten Widerstand (W1 ) und einen zweiten Widerstand (W2) mit dem Verbindunspunkt (V) verbunden ist und die Schalteinrichtung (SE) zwischen dem Masseanschluß (MA) und dem Verbindungspunkt zwischen den Widerständen (W1, W2) liegt.

6. Schaltung nach Anspruch 5, **dadurch gekennzeichnet,** daß die Schalteinrichtung (SE) einen npn-Transistor aufweist.

F i g . 1

F i g . 4

F i g . 2

F i g . 5

Fig. 3